# EUROPÄISCHE PATENTANMELDUNG

(11) **EP 2 182 788 A1**
(43) Veröffentlichungstag der Anmeldung: **05.05.2010**
(21) Anmeldenummer: 09170315.7
(22) Anmeldetag: 15.09.2009
(51) Int. Cl.: H05K 7/14, A47B 88/04

(54) **Halteanordnung für ein Einschubmodul und Trägerrack**

(30) Priorität: 03.11.2008 DE 102008054285
(71) Anmelder: Sinitec Vertriebsgesellschaft mbH, 80807 München (DE)
(72) Erfinder: Aschenmeier, Manfred, 86485, Biberach (DE)
(74) Vertreter: Epping - Hermann - Fischer

(57) **Zusammenfassung**

Die Erfindung betrifft eine Halteanordnung für ein Einschubmodul (1) eines Trägerracks (22), umfassend eine Teleskopschiene (6) aufweisend wenigstens eine erste Halteschiene (5) und eine Trägerschiene (4) zur Aufnahme des Einschubmoduls (1). Die Trägerschiene (4) ist bezüglich der Halteschiene (5) in einer Auszugsrichtung der Teleskopschiene (6) verschiebbar angeordnet und weist wenigstens eine Aufnahmeöffnung (3) zur Aufnahme eines ersten Befestigungsbolzens (2) des Einschubmoduls (1) auf. Die Halteschiene (5) umfasst die Trägerschiene (4) zumindest abschnittsweise, wobei wenigstens ein erster Abschnitt (10) der Halteschiene (5) die wenigstens eine Aufnahmeöffnung (3) der Trägerschiene (4) in einem eingeschobenen Zustand (23) abdeckt.

Die Erfindung betrifft außerdem ein Trägerrack mit einer derartigen Halteanordnung.

## Beschreibung

Die vorliegende Erfindung betrifft eine Halteanordnung für ein Einschubmodul eines Trägerracks, umfassend eine Teleskopschiene aufweisend wenigstens eine erste Halteschiene und eine Trägerschiene zur Aufnahme des Einschubmoduls. Darüber hinaus betrifft die Anmeldung ein Trägerrack mit einem ersten und einem zweiten Seitenteil, einer Rückseite sowie einer Vorderseite mit wenigstens einer Öffnung zum Herausziehen wenigstens eines Einschubmoduls.

Derartige Halteanordnungen und Trägerracks sind vielfach bekannt. Insbesondere aus dem Computerbereich sind Trägerracks zur Aufnahme einer Vielzahl von Einschubmodulen, insbesondere Racksysteme für so genannte Servercomputer, bekannt. Zur leichteren Erweiterbarkeit und Wartung der Einschubmodule sowie zum Hinzufügen, Entfernen und Austauschen einzelner Einschubmodule eines Trägerracks sind die einzelnen Einschubmodule in der Regel mittels Teleskopschienen an den Trägerracks befestigt. Die Teleskopschienen gestatten ein Herausziehen der Einschubmodule aus dem Trägerrack, so dass diese für Wartungsarbeiten frei zugänglich werden.

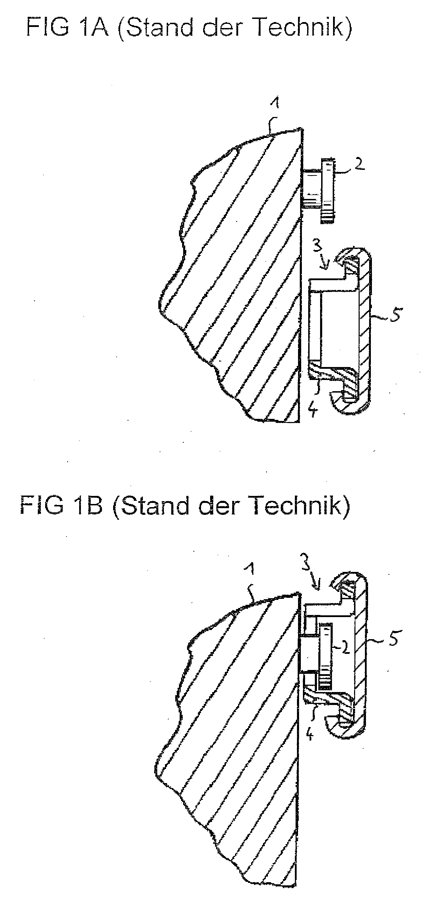

Die Figuren 1A und 1B zeigen Querschnitte durch eine Halteanordnung für ein Einschubmodul mit einer Teleskopschiene gemäß dem Stand der Technik. Ein Einschubmodul 1, beispielsweise ein 19-Zoll-Computergehäuse, weist mehrere Befestigungsbolzen 2 auf, von denen in der Figur 1A jedoch nur ein einzelner ersichtlich ist. Die Befestigungsbolzen 2 greifen in Aufnahmeöffnungen 3 einer Trägerschiene 4 ein. Die Trägerschiene 4 ist beweglich in einer Halteschiene 5 gelagert. Die Halteschiene 5 ist in der Regel an einem Teil einer Seitenwand eines Trägerracks befestigt, insbesondere einer Lochschiene, die eine Montage der Halteschiene 5 auf der gewünschten Höhe gestatten. Dies ist in den Figuren 1A und 1B der Einfachheit halber jedoch nicht dargestellt.

Um ein Einsetzen des Einschubmoduls 1 mit dem Befestigungsbolzen 2 in die Trägerschiene 4 zu ermöglichen, sind die Halteschienen 5 verhältnismäßig flach ausgestaltet, so dass der Befestigungsbolzen 2 in die Aufnahmeöffnung 3 der Trägerschiene 4 eintauchen kann. Um ein versehentliches Lösen des Befestigungsbolzens 2 aus der Aufnahmeöffnung 3 zu verhindern, weisen Halteanordnungen gemäß dem Stand der Technik in der Regel Verschlussvorrichtungen auf, die den Befestigungsbolzen 2 in der Aufnahmeöffnung 3 festhalten.

Je nach Art und Anordnung der Verschlussvorrichtung bedarf es zum Einsetzen beziehungsweise Lösen des Einschubmoduls 1 in die Halteanordnung einer gewissen manuellen Geschicklichkeit und Kraft, um gleichzeitig den Verschlussmechanismus zu öffnen beziehungsweise zu lösen und das Einschubmodul 1 herauszuheben. In der Regel sind daher zwei Personen zur Montage oder Demontage eines Einschubmoduls erforderlich. Des Weiteren sind solche Halteanordnungen verhältnismäßig aufwändig in der Herstellung, da eine Vielzahl von Teilen zu ihrer Herstellung benötigt werden.

Der vorliegenden Erfindung liegt die Aufgabe zugrunde, eine Halteanordnung für ein Einschubmodul sowie ein Trägerrack zur Aufnahme eines Einschubmoduls zu beschreiben, die besonders einfach aufgebaut sind und zugleich eine einfache und sichere Montage der Einschubmodule gestatten. Bevorzugt soll eine werkzeugfreie Montage ermöglicht werden.

Diese Aufgabe wird durch eine Halteanordnung für ein Einschubmodul eines Trägerracks, umfassend eine Teleskopschiene aufweisend wenigstens eine erste Halteschiene und eine Trägerschiene zur Aufnahme des Einschubmoduls, gelöst, wobei die Trägerschiene bezüglich der Halteschiene in einer Auszugsrichtung der Teleskopschiene verschiebbar angeordnet ist und wenigstens eine Aufnahmeöffnung zur Aufnahme eines ersten Befestigungsbolzens eines Einschubmoduls aufweist, die Halteschiene die Trägerschiene zumindest abschnittsweise umfasst und wenigstens ein erster Abschnitt der Halteschiene die wenigstens eine Aufnahmeöffnung der Trägerschiene in einem eingeschobenen Zustand abdeckt und ein Lösen des Befestigungsbolzens verhindert.

Durch die zumindest teilweise Abdeckung der Aufnahmeöffnung durch einen ersten Abschnitt der Halteschiene kann auf zusätzliche Sicherungsmittel zumindest im eingeschobenen Zustand verzichtet werden.

Gemäß einer vorteilhaften Ausgestaltung ist die Halteanordnung **dadurch gekennzeichnet, dass** die wenigstens eine Aufnahmeöffnung der Trägerschiene in einem ersten ausgezogenen Zustand aus der Halteschiene heraustritt, so dass ein Lösen des Befestigungsbolzens aus der Aufnahmeöffnung ermöglicht wird. Wenn die Aufnahmeöffnung der Trägerschiene im ausgezogenen Zustand aus der Halteschiene heraustritt, können Einschubmodule in einem ausgezogenen Zustand auf einfache Weise aus der Teleskopschiene gelöst werden.

Gemäß einer alternativen Ausgestaltung gibt wenigstens ein zweiter Abschnitt der Halteschiene die wenigstens eine Aufnahmeöffnung der Trägerschiene in einem ersten ausgezogenen Zustand frei, so dass ein Lösen des Befestigungsbolzens aus der Aufnahmeöffnung ermöglicht wird. Durch Ausgestaltung eines zweiten Abschnitts der Halteschiene, der ein Lösen des Befestigungsbolzens ermöglicht, ist eine Entnahme eines Einschubmoduls auch in solchen Schienen möglich, bei denen die Aufnahmeöffnung nicht vollständig aus der Trägerschiene heraustritt.

Gemäß einer weiteren vorteilhaften Ausgestaltung ist die Halteanordnung durch einen Feder- oder Rastmechanismus gekennzeichnet, der die Trägerschiene in einem zweiten ausgezogenen Zustand festlegt, in dem wenigstens ein dritter Abschnitt der Halteschiene die wenigstens eine Aufnahmeöffnung der Trägerschiene abdeckt und ein Lösen des Befestigungsbolzens verhindert. Die Verwendung eines Feder- oder Rastmechanismusses zur Festlegung der Trägerschiene in einem zweiten ausgezogenen Zustand, in dem der Befestigungsbolzen gesichert ist, kann ein unbeabsichtigtes Lösen des Befestigungsbolzens aus der Aufnahmeöffnung auch in einem ausgezogenen Zustand verhindert werden.

Gemäß einer weiteren vorteilhaften Ausgestaltung weist die Trägerschiene wenigstens eine zweite Aufnahmeöffnung zur Aufnahme eines zweiten Befestigungsbolzens des Einschubmoduls auf, wobei die erste Aufnahmeöffnung in einem in Richtung der Halteschiene weisenden Abschnitt der Trägerschiene und die zweite Aufnahmeöffnung in einem in Auszugsrichtung der Halteschiene weisenden Abschnitts der Trägerschiene angeordnet ist. Die Verwendung von wenigstens zwei Aufnahmeöffnungen gestattet die Befestigung des Einschubmoduls an der Trägerschiene 4 ohne zusätzliche Teile, insbesondere Schrauben. Gemäß einer vorteilhaften Ausgestaltung sind die erste und/oder die zweite Aufnahmeöffnung im Wesentlichen U-förmig ausgestaltet und weisen eine nach oben weisende Öffnung zur Entnahme des Befestigungsbolzens aus der Aufnahmeöffnung auf. Gemäß einer alternativen Ausgestaltung sind die erste und/oder die zweite Aufnahmeöffnung im Wesentlichen L-förmig ausgestaltet und weisen eine nach oben weisende Öffnung zur Entnahme des Befestigungsbolzen in einem ersten Teilbereich der Aufnahmeöffnung und einen Vorsprung zum Halten des Befestigungsbolzens in einem zweiten Teilbereich der Aufnahmeöffnung auf, wobei der Befestigungsbolzen durch Verschieben des Einschubmoduls in Auszugsrichtung aus dem ersten in den zweiten Teilbereich oder umgekehrt verschiebbar ist. Die Verwendung von U-förmigen beziehungsweise L-förmigen Aufnahmeöffnungen erlaubt eine einfache Montage der Einschubmodule durch Einschieben der Befestigungsbolzen von oben in die Aufnahmeöffnung der Halteschiene. Sofern die Aufnahmeöffnung L-förmig ausgestaltet ist und einen Vorsprung zum Halten der Aufnahmeöffnung in einem zweiten Teilbereich der Aufnahmeöffnung aufweist, kann ein unbeabsichtigtes Lösen der Befestigungsbolzen durch eine nach oben wirkende Kraft verhindert werden.

Gemäß einer weiteren vorteilhaften Ausgestaltung weist der erste und/oder zweite Befestigungsbolzen einen ersten im Wesentlichen zylinderförmigen Teilkörper und einen zweiten im Wesentlichen zylinderförmigen Teilkörper auf, wobei der ersten zylinderförmige Teilkörper einen ersten Durchmesser aufweist, der im Wesentlichen der lichten Weite der zugehörigen Aufnahmeöffnung entspricht, und der zweite zylinderförmige Teilkörper einen zweiten Durchmesser aufweist, der größer als der erste Durchmesser ist, wobei eine Außenfläche des zweiten zylinderförmigen Teilkörpers in einem in die zugehörige Aufnahmeöffnung der Trägerschiene aufgenommenen und in die Halteschiene eingeschobenen Zustand an dem ersten Abschnitt anliegt. Durch Gestaltung des Befestigungsbolzens derart, dass eine Außenfläche eines zweiten zylinderförmigen Teilkörpers im eingeschobenen Zustand an dem ersten Abschnitt der Trägerschiene anliegt, wird eine spielfreie Befestigung des Einschubmoduls bewirkt.

Die zugrunde liegende Aufgabe wird ebenso gelöst durch ein Trägerrack mit den Merkmalen des Patentanspruchs 12.

Weitere vorteilhafte Ausgestaltungen der vorliegenden Erfindung sind in den Patentansprüchen sowie der nachfolgenden detaillierten Beschreibung von Ausführungsbeispielen näher erläutert.

Die Erfindung wird nachfolgend anhand von in den Figuren dargestellten Ausführungsbeispielen näher beschrieben, wobei gleiche Bezugszeichen für gleichartige Komponenten verwendet werden. In den Figuren zeigen:
- Figur 1A und 1B: Querschnitte durch eine Halteanordnung gemäß dem Stand der Technik,
- Figur 2: einen Querschnitt durch eine Halteanordnung gemäß einem ersten Ausführungsbeispiel,
- Figur 3: eine perspektivische Ansicht der Halteanord- nung gemäß dem ersten Ausführungsbeispiel,
- Figur 4A bis 4C: Querschnitte durch eine Halteanordnung wäh- rend des Einbau eines Einschubmoduls,
- Figur 5A bis 5C: eine Aufsicht sowie zwei Seitenansichten auf eine Halteanordnung gemäß einem zweiten Aus- führungsbeispiel,
- Figur 6: eine Seitenansicht einer Halteanordnung ge- mäß einem dritten Ausführungsbeispiel,
- Figur 7: eine Seitenansicht einer Halteanordnung ge- mäß einem vierten Ausführungsbeispiel und
- Figur 8A und 8B: eine Seitenansicht sowie ein Aufsicht auf eine Halteanordnung gemäß einem fünften Aus- führungsbeispiel.

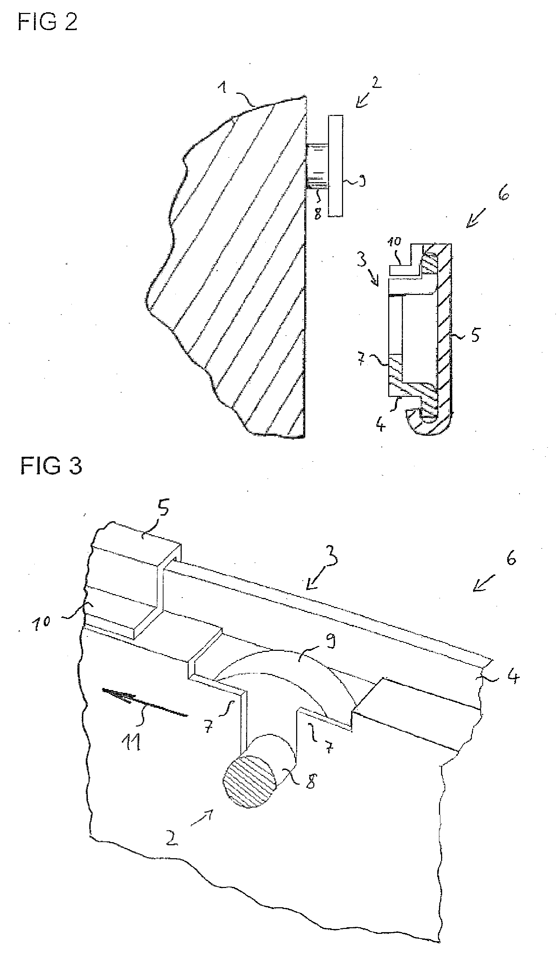

Figur 2 zeigt einen Querschnitt durch eine Halteanordnung gemäß einem ersten Ausführungsbeispiel der Erfindung. In ihr ist ein Einschubmodul 1 mit einem daran angeordneten Befestigungsbolzen 2 zu erkennen. Der Befestigungsbolzen 2 dient zur Befestigung des Einschubmoduls 1 in einer Teleskopschiene 6. Selbstverständlich können anstelle der aufgesetzten Befestigungsbolzen 2 auch Haken oder andere Gehäuseausformungen Verwendung finden. Die Teleskopschiene 6 ist im dargestellten Ausführungsbeispiel zweiteilig ausgeführt und umfasst eine Trägerschiene 4 sowie eine Halteschiene 5. Die Trägerschiene 4 dient zur Festlegung des Einschubmoduls 1 an der Teleskopschiene 6. Die Halteschiene 5 umfasst die Trägerschiene 4 teilweise und dient zur Festlegung der Halteschiene 5 an einem in der Figur 2 nicht dargestellten Trägerrack. Insbesondere handelt es sich bei der Halteschiene 5 um einen so genannten Rollenkäfig, in dem Trägerschiene 4 beweglich gelagert ist. Im gemäß der Figur 2 dargestellten Querschnitt lässt sich die Trägerschiene 4 senkrecht zur dargestellten Schnittebene in der Halteschiene 5 verschieben.

Die Trägerschiene 4 weist eine Aufnahmeöffnung 3 auf, die derart ausgestaltet ist, dass der Befestigungsbolzen 2 in sie eingreifen kann. Hierzu umfasst der Befestigungsbolzen 2 einen ersten Teilkörper 8 und einen zweiten Teilkörper 9. Der zweite Teilkörper 9 weist einen größeren Durchmesser als der erste Teilkörper 8 auf und greift im aufgenommenen Zustand hinter einen Vorsprung 7 der Trägerschiene 4, so dass ein Lösen des Befestigungsbolzens 2 in seitlicher Richtung aus der Trägerschiene 4 verhindert wird.

In der in der Figur 2 dargestellten Schnittebene umfasst die Halteschiene 5 die Trägerschiene 4 nur im schraffiert dargestellten Bereich. Insbesondere kann der Befestigungsbolzen 2 von oben her in die Aufnahmeöffnung 3 eingeschoben werden. In einem weiteren Bereich der Halteschiene 5 weist diese jedoch einen ersten Abschnitt 10 auf, der die Aufnahmeöffnung 3 beim Einschieben der Trägerschiene 4 in die Halteschiene 5 zumindest teilweise abdeckt und somit ein Lösen des Befestigungsbolzens 2 aus der Aufnahmeöffnung 3 verhindert. Dieser erste Abschnitt 10 ist in der Schnittansicht gemäß Figur 2 nicht mit einer Schraffur versehen.

Figur 3 zeigt eine perspektivische Ansicht der Halteanordnung gemäß dem ersten Ausführungsbeispiel. Aus Gründen der einfacheren Darstellung ist in der Figur 3 weder das Einschubmodul 1 noch das Trägerrack dargestellt.

Figur 3 zeigt die Teleskopschiene 6 in einem vollständig ausgezogenen Zustand. Durch den Pfeil 11 wird die Einschubrichtung der Teleskopschiene 6 angezeigt. In dem vollständig ausgezogenen Zustand tritt die Aufnahmeöffnung 3 der Trägerschiene 4 vollständig aus der Halteschiene 5 heraus. Somit kann der Befestigungsbolzen 2 im vollständig ausgezogenen Zustand nach oben aus der Trägerschiene 4 gelöst werden. Verschiebt man die Trägerschiene 4 jedoch in der durch den Pfeil 11 angedeuteten Richtung in die Halteschiene 5 hinein, deckt deren erster Abschnitt 10 automatisch die Aufnahmeöffnung 3 der Trägerschiene 4 ab, so dass ein Lösen des Befestigungsbolzens 2 in einem eingeschobenen Zustand verhindert wird.

In der Figur 3 ist zu erkennen, dass der Durchmesser des Befestigungsbolzens 2 so gewählt wurde, dass er an dem ersten Abschnitt 10 der Halteschiene 5 im Wesentlichen anliegt. Somit ist eine weitgehend spielfreie Lagerung des Befestigungsbolzens 2 im eingeschobenen Zustand möglich. Werden entweder der erste Teilkörper 8 oder der zweite Teilkörper 9 des Befestigungsbolzens 2 exzentrisch ausgeführt (nicht dargestellt), kann durch Drehung des Befestigungsbolzens zugleich eine Höhenjustage des Einschubmoduls 1 vorgenommen werden, beispielsweise um eine Frontplatte des Einschubmoduls 1 waagerecht auszurichten oder an andere, bereits montierte Einschubmodule anzupassen.

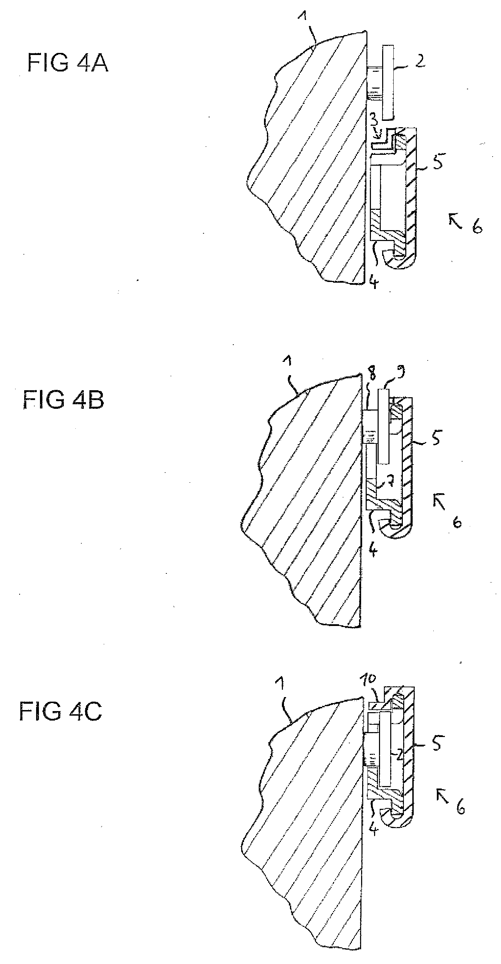

Die Figuren 4A bis 4C zeigen eine Montage eines Einschubmoduls 1 mittels einer Halteanordnung gemäß der ersten Ausgestaltung. In der Figur 1A ist das Einschubmodul noch nicht an der Teleskopschiene 6 festgelegt. Hierzu wird der Befestigungsbolzen 2 zunächst in horizontaler Richtung über der Aufnahmeöffnung 3 ausgerichtet. Die Trägerschiene 4 befindet sich zu diesem Zeitpunkt in einem vollständig ausgezogenen Zustand, so dass der erste Abschnitt 10 der Halteschiene 5 die Aufnahmeöffnung 3 nicht abdeckt.

In der Figur 4B ist das Eintreten des Befestigungsbolzens 2 in die Aufnahmeöffnung 3 dargestellt. Der zweite Teilkörper 9 des Befestigungsbolzens 2 tritt in die Aufnahmeöffnung 3 ein und wird in horizontaler Richtung durch einen Vorsprung 7 der Trägerschiene 4 gesichert.

In der Figur 4C ist das Einschubmodul in einem zumindest teilweise eingeschobenen Zustand dargestellt. Darin ist zu erkennen, dass der erste Abschnitt 10 der Halteschiene 5 die Aufnahmeöffnung 3 der Trägerschiene 4 nach oben hin abdeckt. Daher kann der Befestigungsbolzen 2 nicht mehr aus der Aufnahmeöffnung 3 heraustreten und ist in jeder Raumrichtung durch die Halteanordnung gesichert. Somit bedarf es im eingeschobenen Zustand keiner weiteren Sicherungsmittel, um das Einschubmodul 1 an der Teleskopschiene 6 zu befestigen.

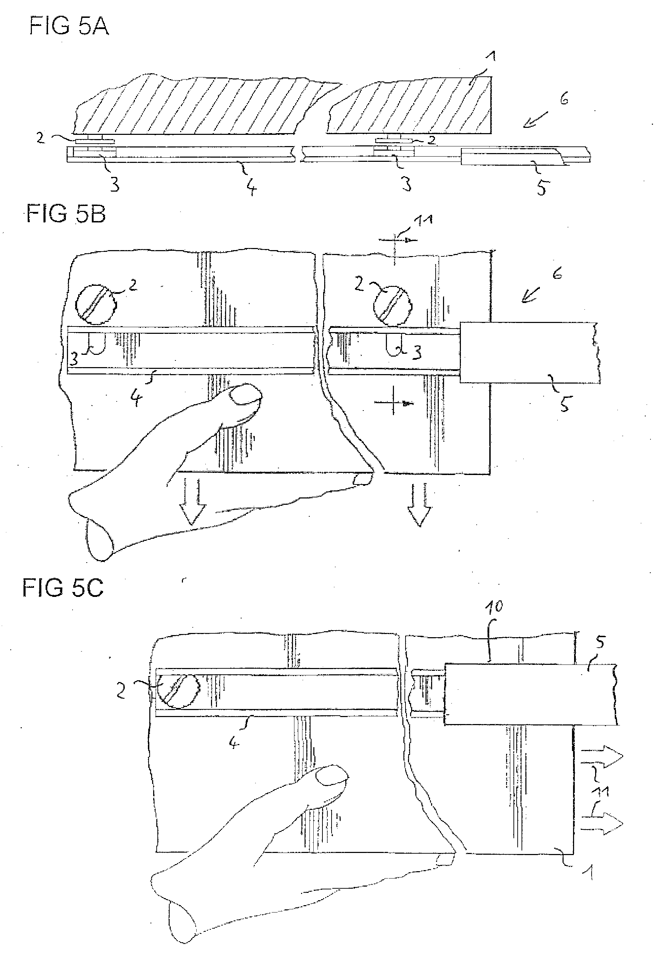

Die Figuren 5A bis 5C zeigen ein zweites Ausführungsbeispiel der Erfindung. In der Figur 5A ist eine Aufsicht und in den Figuren 5B und 5C jeweils eine Seitenansicht auf die Halteanordnung vor und nach Einführen der Befestigungsbolzen 2 in die Trägerschiene 4 dargestellt.

In der Aufsicht der Figur 5A ist zu erkennen, dass das Einschubmodul 1 zwei seitlich angeordnete Befestigungsbolzen 2 aufweist. Die Befestigungsbolzen 2 können in U-förmig ausgeformte Aufnahmeöffnungen 3 einer Trägerschiene 4 eintauchen. Die Aufnahmeöffnungen 3 sind im ausgezogenen Zustand der Trägerschiene 4 von oben zugänglich. Wird die Trägerschiene 4 jedoch in eine Halteschiene 5 eingeschoben, im dargestellten Ausführungsbeispiel also nach rechts, werden die Aufnahmeöffnungen 3 durch die Halteschiene 5 abgedeckt.

Figur 5B zeigt das Einschubmodul 1 während der Montage in der Halteanordnung. Die Befestigungsbolzen 2, im dargestellten Ausführungsbeispiel in das Einschubmodul eingeschraubte Schrauben, werden in horizontaler Richtung über den Aufnahmeöffnungen 3 ausgerichtet. Dann wird das Einschubmodul 1 mit den daran befestigten Befestigungsbolzen 2 zunächst nach unten herabgelassen, so dass die Befestigungsbolzen 2 in die Aufnahmeöffnungen 3 eintreten.

In einem nachfolgenden Schritt wird das Einschubmodul 1 in Richtung des Pfeils 11 in die Teleskopschiene 6 eingeschoben, so dass die Trägerschiene 4 zumindest teilweise in die Halteschiene 5 eintritt. Dabei verhindert ein erster Abschnitt 10 der Halteschiene 5 ein Heraustreten der Befestigungsbolzen 2 nach oben. Dies ist in der Figur 5C dargestellt.

Wie aus den Figuren 5A bis 5C ersichtlich, muss der Monteur keine zusätzlichen Sicherungsmittel der Trägerschiene 4 oder der Halteschiene 5 bedienen. Somit hat er seine Hände zur Ausrichtung und zum Halten des Einschubmoduls 1 während der Montage frei. Dies ermöglicht insbesondere die Montage eines Einschubmoduls 1 durch einen einzelnen Monteur.

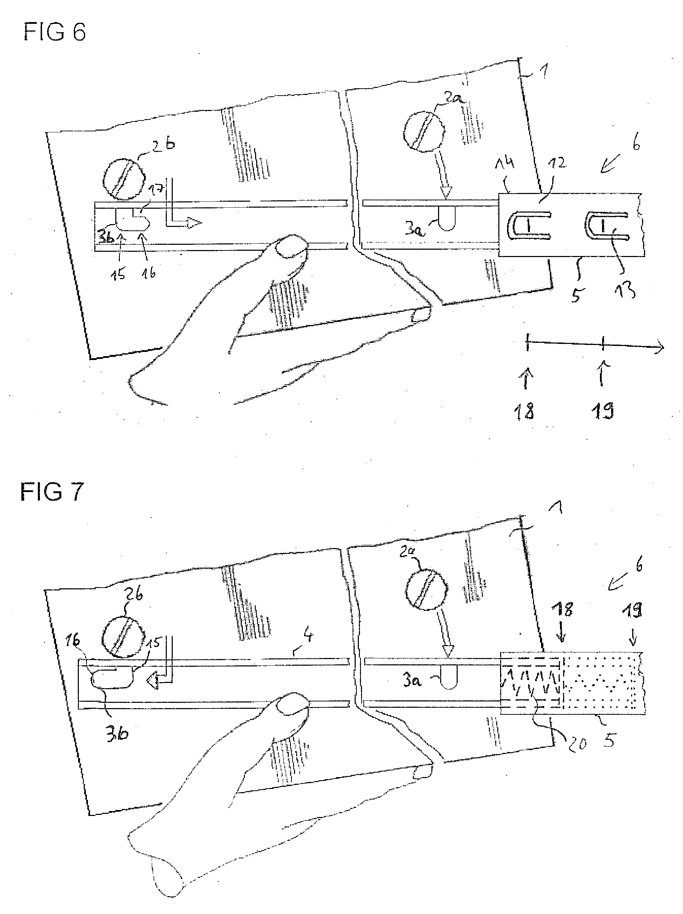

Figur 6 zeigt eine weitere Ausgestaltung einer Halteanordnung zur Aufnahme eines Einschubmoduls 1. Die Halteanordnung gemäß Figur 6 unterscheidet sich insbesondere dadurch von der Halteanordnung gemäß der ersten und der zweiten Ausgestaltung, dass die Halteschiene 5 ein erstes sowie ein zweites Rastmittel 12 beziehungsweise 13 aufweist, die die Trägerschiene 4 wahlweise in einem ersten ausgezogenen Zustand 18 beziehungsweise zweiten ausgezogenen Zustand 19 festlegen. Die Figur 6 zeigt die Trägerschiene 4 in dem ersten ausgezogenen Zustand 18.

Ist die Trägerschiene 4 mittels des ersten Rastmittels 12 in dem ersten ausgezogenen Zustand 18 festgelegt, sind zwei Aufnahmeöffnungen 3a beziehungsweise 3b der Trägerschiene 4 von oben zugänglich. Somit können korrespondierende Befestigungsbolzen 2a und 2b eines Einschubmoduls 1 von oben in die Aufnahmeöffnungen 3a bzw. 3b eingeführt werden.

Ist die Trägerschiene 4 mittels des zweiten Rastmittels 13 jedoch in dem zweiten ausgezogenen Zustand 19 festgelegt, ist zumindest die hintere Aufnahmeöffnung 3a durch einen Abschnitt 14 der Halteschiene 5 abgedeckt. Somit ist ein Herausnehmen des Einschubmoduls 1 in dem ersten eingeschobenen Zustand 18 nicht möglich.

Befindet sich das Einschubmodul 1 zunächst in einem vollständig eingeschobenen Zustand, wird es durch Herausziehen zunächst in den zweiten ausgezogenen Zustand 19 bewegt, in dem ein Lösen des Befestigungsbolzens 2a aus der hinteren Aufnahmeöffnung 3a noch nicht möglich ist. In diesem zweiten ausgezogenen Zustand ist somit eine Wartung des Einschubmoduls 1 möglich, ohne dass die Verbindung zwischen dem Einschubmodul 1 und der Teleskopschiene 6 gelöst würde. Nur in dem Fall, dass das Einschubmodul 1 vollständig aus einem Trägerrack entfernt werden soll, kann das Einschubmodul 1 und damit die Trägerschiene 4 weiter aus der Teleskopschiene 6 herausgezogen werden, wobei diese mittels des ersten Rastmittels 12 in dem ersten ausgezogenen Zustand 18 verrastet, der eine Entnahme des Einschubmoduls 1 gestattet.

Um auch ein Lösen des vorderen Befestigungsbolzens 2b aus der vorderen Aufnahmeöffnung 3b zu verhindern, ist sie L-förmig ausgestaltet. Bei der in der Figur 6 dargestellten Montage des Einschubmoduls 1 wird zunächst der vordere Befestigungsbolzen 2b in einen ersten Teilbereich 15 der vorderen Aufnahmeöffnung 3b eingeführt. Durch Verschieben des Einschubmoduls 1 in Einschubrichtung, in der Figur 6 nach rechts, wird der vordere Befestigungsbolzen 2b dann in einen zweiten Teilbereich 16 der Trägerschiene 4 verschoben, wobei erst in diesem Zustand die Aufnahme des hinteren Befestigungsbolzens 2a in die hintere Aufnahmeöffnung 3a ermöglicht wird. In diesem Zustand sichert ein Vorsprung 17 der Trägerschiene 4 den vorderen Befestigungsbolzen 2b vor einem Heraustreten aus der vorderen Aufnahmeöffnung 3b. Ein unbeabsichtigtes Aushebeln des vorderen Befestigungsbolzens 2b ist daher nicht möglich. Wird das Einschubmodul 1 weiter in Einschubrichtung verschoben, tritt die Trägerschiene 4 soweit in die Halteschiene 5 ein, dass der Abschnitt 14 der Halteschiene 5 zusätzlich die hintere Aufnahmeöffnung 3a abdeckt und das Einschubmodul 1 somit in jeder Raumrichtung an der Teleskopschiene 6 festgelegt ist.

Figur 7 zeigt eine weitere Ausgestaltung einer Halteanordnung. Auch die Halteanordnung gemäß Figur 7 umfasst eine Teleskopschiene 6 mit einer Halteschiene 5 und einer Trägerschiene 4. Die Trägerschiene 4 weist zwei Aufnahmeöffnungen 3a und 3b in einem hinteren beziehungsweise vorderen Teilbereich der Trägerschiene 4 auf. Anders als in dem in der Figur 6 dargestellten Ausführungsbeispiel weist ein zweiter Teilbereich 16 der vorderen Aufnahmeöffnung 3b in Richtung der Auszugsrichtung, also in der Figur 7 nach links, entgegengesetzt zur Einschubrichtung. Die hintere Aufnahmeöffnung 3a ist U-förmig ausgeführt.

Wird der vordere Befestigungsbolzen 2b zunächst in den ersten Teilbereich 15 und nachfolgend in den zweiten Teilbereich 16 der vorderen Aufnahmeöffnung 3b eingeführt, kann die Trägerschiene 4 durch Ziehen des Einschubmoduls 1 in Auszugsrichtung aus einem zweiten ausgezogenen Zustand 19 in einen ersten ausgezogenen Zustand 18 gestreckt werden. Nur in diesem, ersten ausgezogenen Zustand 18 wird die hintere Aufnahmeöffnung 3a freigegeben, so dass der hintere Befestigungsbolzen 2a in diese eingeführt werden kann.

Nachfolgend gleitet die Trägerschiene 4 in der Halteschiene 5 in den zweiten ausgezogenen Zustand 19 zurück, in dem die hintere Aufnahmeöffnung 3a nach oben abgedeckt ist. Hierzu wird die Trägerschiene 4 in dem zweiten ausgezogenen Zustand 19 durch ein Federelement 20 gehalten. In der Figur 7 ist der entspannte Zustand des Federelementes 20 gepunktet angedeutet. Im ersten ausgezogenen Zustand 18 ist das Federelement 20 hingegen komprimiert, dies ist in der Figur 7 durch eine gestrichelte Linie angedeutet. Selbstverständlich können auch andere Mittel anstelle einer Feder Verwendung finden, solange die Trägerschiene 4 dadurch bevorzugt von dem ersten ausgezogenen Zustand 18 in den zweiten ausgezogenen Zustand 19 bewegt oder dort gehalten wird.

Somit befindet sich das Einschubmodul 1 ohne Einwirkung externer Kräfte stets in dem gesicherten, zweiten ausgezogenen Zustand 19 oder einem ganz oder teilweise eingeschobenen Zustand, in dem ein Lösen der Befestigungsbolzen 2 aus den Aufnahmeöffnungen 3 nicht möglich ist. Gleichzeitig ist zum Einsetzen oder Herausnehmen des Einschubmoduls 1 lediglich eine geringe Zugkraft nach vorne erforderlich, so dass das Einschubmodul 1 werkzeugfrei in der Halteanordnung befestigt werden kann. Auch die Ausgestaltung gemäß Figur 7 erlaubt somit eine einfache Montage eines Einschubmoduls 1 durch einen einzelnen Monteur.

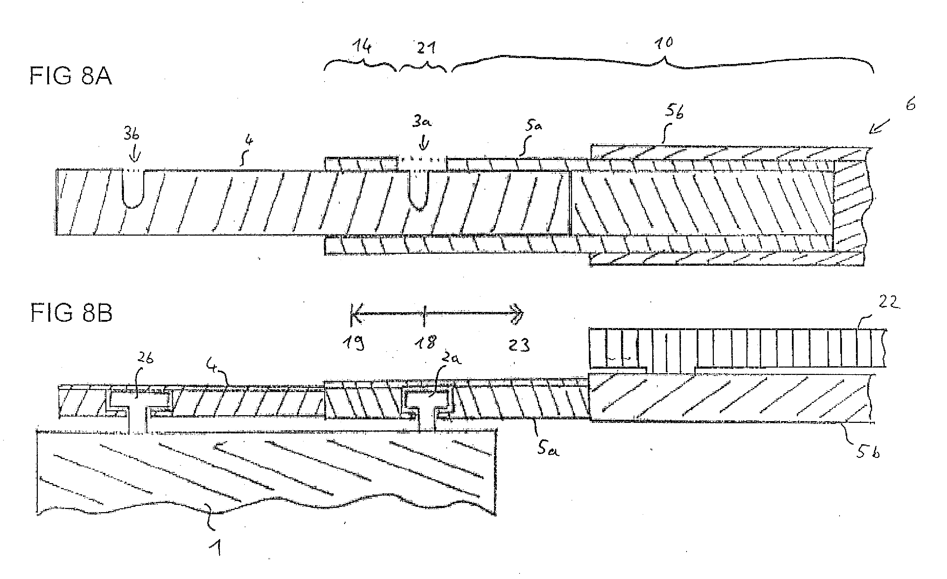

Die Figuren 8A und 8B zeigen eine weitere Ausgestaltung einer erfindungsgemäßen Haltevorrichtung. Im Unterschied zu den zuvor beschriebenen Ausführungsbeispielen ist die Teleskopschiene 6 gemäß den Figuren 8A und 8B dreiteilig ausgestaltet.

Eine Trägerschiene 4 weist zwei Aufnahmeöffnungen 3a und 3b auf, die zur Festlegung der Trägerschiene 4 an einem Einschubmodul 1 mittels Befestigungsbolzen 2a bzw. 2b dienen. Die Trägerschiene 4 ist beweglich in einer ersten Halteschiene 5a gelagert. Die erste Halteschiene 5a weist eine Öffnung auf, durch die der Befestigungsbolzen 2a hindurch treten kann, und somit in die hintere Aufnahmeöffnung 3a der innen liegenden Trägerschiene 4 eingeführt werden kann. Die erste Halteschiene 5a ist ihrerseits beweglich in einer zweiten Halteschiene 5b gelagert, so dass die Trägerschiene 4 bezogen auf die zweite Halteschiene 5b in ihrer ganzen Länge aus einem Trägerrack 22 herausgezogen werden kann. Die zweite Halteschiene 5b ist an einem Seitenteil des Trägerracks 22 befestigt, wie dies in der Figur 8b dargestellt ist.

Die erste Halteschiene 5a weist einen ersten Abschnitt 10 in einem hinteren Bereich, einen zweiten Abschnitt 21 in einem mittleren Bereich und einen dritten Abschnitt 14 in einem vorderen Bereich auf. Im ersten Abschnitt 10 sowie im dritten Abschnitt 14 umfasst die erste Halteschiene 5a die Trägerschiene 4 so weit, dass ein in die hintere Aufnahmeöffnung 3a eingesetzter Befestigungsbolzen 2a nicht aus der Aufnahmeöffnung 3b herausgenommen werden kann. Nur im mittleren, zweiten Abschnitt 21 umfasst die erste Halteschiene 5a die Trägerschiene 4 nur so weit, dass ein Befestigungsbolzen 2a in die Aufnahmeöffnung 3a eingesetzt beziehungsweise aus ihr entnommen werden kann. Somit ist ein in die Aufnahmeöffnung 3a eingesetzter Befestigungsbolzen 2a sowohl in einem vollständig ausgezogenen Zustand 19 sowie einem eingeschobenen Zustand 23 durch die erste Halteschiene 5a gesichert. Nur in einem teilweise ausgezogenen Zustand 18 ist eine Montage beziehungsweise eine Entnahme eines Einschubmoduls 1 an der Teleskopschiene 6 möglich. Durch die zweite Halteschiene 5b kann eine zusätzliche oder alternative Sicherung der Befestigungsbolzen 2 in den Aufnahmeöffnungen 3 bewirkt werden.

Die in den unterschiedlichen Ausführungsbeispielen in den Figuren 2 bis 8B dargestellten Befestigungsmittel können in nahezu beliebiger Weise miteinander kombiniert werden. Dabei ist es grundsätzlich ausreichend, wenn wenigstens eine einzelne Haltevorrichtung gemäß einem der Ausführungsbeispiele zur Befestigung eines Einschubmoduls 1 an einem Trägerrack 22 verwendet wird. Aus Gründen der einfacheren Montage und gemeinsamen Herstellung ist es jedoch auch von Vorteil, sowohl auf der rechten wie auch der linken Seite eines Einschubmoduls eine der Halteanordnungen gemäß einem der Ausführungsbeispiele vorzusehen.

### Bezugszeichenliste

- 1: Einschubmodul
- 2: Befestigungsbolzen
- 3: Aufnahmeöffnung
- 4: Trägerschiene
- 5: Halteschiene
- 6: Teleskopschiene
- 7: Vorsprung
- 8: erster Teilkörper
- 9: zweiter Teilkörper
- 10: (erster) Abschnitt
- 11: Pfeil (in Einschubrichtung)
- 12: erstes Rastmittel
- 13: zweites Rastmittel
- 14: (dritter) Abschnitt
- 15: erster Teilbereich
- 16: zweiter Teilbereich
- 17: Vorsprung
- 18: (erster) ausgezogener Zustand
- 19: (zweiter) ausgezogener Zustand
- 20: Federelement
- 21: (zweiter) Abschnitt
- 22: Trägerrack
- 23: eingeschobener Zustand

## Patentansprüche

1. Halteanordnung für ein Einschubmodul (1) eines Trägerracks (22), umfassend eine Teleskopschiene (6) aufweisend wenigstens eine erste Halteschiene (5) und eine Trägerschiene (4) zur Aufnahme des Einschubmoduls (1), wobei die Trägerschiene (4) bezüglich der Halteschiene (5) in einer Auszugsrichtung der Teleskopschiene (6) verschiebbar angeordnet ist und wenigstens eine Aufnahmeöffnung (3) zur Aufnahme eines ersten Befestigungsbolzens (2) eines Einschubmoduls (1) aufweist, die Halteschiene (5) die Trägerschiene (4) zumindest abschnittsweise, im Wesentlichen U-förmig umfasst und wenigstens ein erster Abschnitt (10) der Halteschiene (5) die wenigstens eine Aufnahmeöffnung (3) der Trägerschiene (4) in einem eingeschobenen Zustand (23) abdeckt und ein Lösen des Befestigungsbolzens (2) verhindert.

2. Halteanordnung nach Anspruch 1,
**dadurch gekennzeichnet, dass**
die wenigstens eine Aufnahmeöffnung (3) der Trägerschiene (4) in einem ersten ausgezogenen Zustand (18) aus der Halteschiene (5) heraustritt, so dass ein Lösen des Befestigungsbolzens (2) aus der Aufnahmeöffnung (3) ermöglicht wird.

3. Halteanordnung nach Anspruch 1,
**dadurch gekennzeichnet, dass**
wenigstens ein zweiter Abschnitt (21) der Halteschiene (5) die wenigstens eine Aufnahmeöffnung (3) der Trägerschiene (4) in einem ersten ausgezogenen Zustand (18) freigibt, so dass ein Lösen des Befestigungsbolzens (2) aus der Aufnahmeöffnung (3) ermöglicht wird.

4. Halteanordnung nach einem der Ansprüche 1 bis 3,
**gekennzeichnet durch**
einen Feder- oder Rastmechanismus, der die Trägerschiene (4) in einem zweiten ausgezogenen Zustand (19) festlegt, in dem wenigstens ein dritter Abschnitt (14) der Halteschiene (5) die wenigstens eine Aufnahmeöffnung (3) der Trägerschiene (4) abdeckt und ein Lösen des Befestigungsbolzens (2) verhindert.

5. Halteanordnung nach einem der Ansprüche 1 bis 4,
**dadurch gekennzeichnet, dass**
die Trägerschiene (4) wenigstens eine zweite Aufnahmeöffnung (3b) zur Aufnahme eines zweiten Befestigungsbolzens (2b) des Einschubmoduls (1) aufweist, wobei die erste Aufnahmeöffnung (3a) in einem in Richtung der Halteschiene (5) weisenden Abschnitts der Trägerschiene (4) und die zweite Aufnahmeöffnung (3b) in einem in Auszugsrichtung der Halteschiene (5) weisenden Abschnitts der Trägerschiene (4) angeordnet ist.

6. Halteanordnung nach einem der Ansprüche 1 bis 5,
**dadurch gekennzeichnet, dass**
die erste und/oder zweite Aufnahmeöffnung (3) im Wesentlichen U-förmig ausgestaltet ist und eine nach oben weisende Öffnung zur Entnahme des Befestigungsbolzens (2) aus der Aufnahmeöffnung (3) aufweist.

7. Halteanordnung nach einem der Ansprüche 1 bis 6,
**dadurch gekennzeichnet, dass**
die erste und/oder die zweite Aufnahmeöffnung (3) im Wesentlichen L-förmig ausgestaltet ist und eine nach oben weisende Öffnung zur Entnahme des Befestigungsbolzens (2) in einem ersten Teilbereich der Aufnahmeöffnung (3) aufweist und einen Vorsprung (17) zum Halten des Befestigungsbolzens (2) in einem zweiten Teilbereich (16) der Aufnahmeöffnung (3) aufweist, wobei der Befestigungsbolzen (2) durch Verschieben des Einschubmoduls (1) in Auszugsrichtung aus dem ersten Teilbereich (15) in den zweiten Teilbereich (16) oder umgekehrt verschiebbar ist.

8. Halteanordnung nach einem der Ansprüche 1 bis 7,
**dadurch gekennzeichnet, dass**
der erste und/oder zweite Befestigungsbolzen (2) einen ersten, im Wesentlichen zylinderförmigen Teilkörper (8) und einen zweiten, im Wesentlichen zylinderförmigen Teilkörper (9) aufweist, wobei der erste zylinderförmige Teilkörper (8) einen ersten Durchmesser aufweist, der im Wesentlichen der lichten Weite der zugehörigen Aufnahmeöffnung (3) entspricht, und der zweite zylinderförmige Teilkörper (9) einen zweiten Durchmesser aufweist, der größer als der erste Durchmesser ist, wobei eine Außenfläche des zweiten zylinderförmigen Teilkörpers (9) in einem in der zugehörigen Aufnahmeöffnung (3) der Trägerschiene (4) aufgenommenen und in die Halteschiene (5) eingeschobenen Zustand (23) an dem ersten Abschnitt (10) anliegt.

9. Halteanordnung nach einem der Ansprüche 1 bis 8,
**dadurch gekennzeichnet, dass**
wenigstens ein Teilkörper (8, 9) des ersten Befestigungsbolzens (2) exzentrisch ausgebildet ist.

10. Halteanordnung nach einem der Ansprüche 1 bis 9,
**dadurch gekennzeichnet, dass**
die Teleskopschiene (6) zweiteilig ausgeführt ist, wobei die erste Halteschiene (5) an dem Trägerrack (22) befestigbar ist.

11. Halteanordnung nach einem der Ansprüche 1 bis 10,
**dadurch gekennzeichnet, dass**
die Teleskopschiene (6) dreiteilig ausgeführt ist und eine zweite Halteschiene (5b) umfasst, wobei die erste Halteschiene (5a) bezüglich der zweiten Halteschiene (5b) in Auszugsrichtung verschiebbar ist und durch diese gehalten wird und die zweite Halteschiene (5b) an dem Trägerrack (22) befestigbar ist.

12. Trägerrack (22) mit einem ersten und einem zweiten Seitenteil, einer Rückseite sowie einer Vorderseite mit wenigstens einer Öffnung zum Herausziehen wenigstens eines Einschubmoduls (1), umfassend wenigstens eine im Bereich des ersten Seitenteils angeordnete erste Halteanordnung und eine im Bereich des zweiten Seitenteils angeordnete zweite Halteanordnung zur Aufnahme des wenigstens einen Einschubmoduls (1), wobei wenigstens die erste Halteanordnung sämtliche Merkmale der Halteanordnung gemäß einem der Ansprüche 1 bis 11 aufweist.

13. Trägerrack nach Anspruch 12, **dadurch gekennzeichnet, dass** auch die zweite Halteanordnung sämtliche Merkmale einer Halteanordnung gemäß einem der Ansprüche 1 bis 11 aufweist.
